Europäisches Patentamt

European Patent Office

Office européen des brevets

(19)

(11) Numéro de publication : **0 632 276 A1**

## (12) DEMANDE DE BREVET EUROPEEN

(21) Numéro de dépôt : **94401455.4**

(22) Date de dépôt : **28.06.94**

(51) Int. Cl.[6] : **G01R 7/00**, G01D 7/00

(30) Priorité : **29.06.93 FR 9307898**

(43) Date de publication de la demande :
**04.01.95 Bulletin 95/01**

(84) Etats contractants désignés :
**DE GB IT**

(71) Demandeur : **SOCIETE D'APPLICATIONS GENERALES D'ELECTRICITE ET DE MECANIQUE SAGEM**
**6, Avenue d'Iéna**
**F-75783 Paris Cédex 16 (FR)**

(72) Inventeur : **Leleu, Joel**
**8 Le Clos des Roches**
**F-95450 Sagy (FR)**

(74) Mandataire : **Bloch, Gérard et al**
**2, square de l'Avenue du Bois**
**F-75116 Paris (FR)**

(54) **Procédé d'utilisation d'un indicateur à curseur mobile.**

(57)   Procédé d'utilisation d'un indicateur à curseur mobile (1) entraîné devant un cadran (2) par un moteur commandé par micro-pas (10) en fonction d'un signal à afficher (4), dans lequel :
. on règle d'abord le signal à afficher (4) pour que le curseur (1) affleure la butée (20) et on mémorise la position correspondante dans le pas, puis
. on ramène, par des micro-pas de pas successifs, le curseur (1) vers la butée (20), en sautant, dans chaque pas, les positions situées dans la plage du pas pour lesquelles l'écart, entre les positions des micro-pas et celle de la butée (20), est supérieur à un demi-pas.
- Application aux compte-tours.

FIG.1

EP 0 632 276 A1

Un indicateur à curseur mobile sert par exemple, dans une voiture, à afficher la vitesse de celle-ci. Le curseur est souvent une aiguille entraînée en rotation, devant un cadran portant des indications de vitesse, par un mouvement d'entraînement. On comprendra bien que la présente invention ne concerne pas les indicateurs du type à pluralité de volets mobiles pouvant prendre deux positions stables dont l'une permet de voir des inscriptions présentes sur une des faces du volet.

On connaît déjà des indicateurs de type galvanomètre, logomètre ou logomètre à bobines croisées, pour lesquels l'aiguille est solidaire d'une pièce magnétique l'entraînant sous l'effet du déplacement d'un champ magnétique créé par des bobines. Ces indicateurs sont cependant assez coûteux si l'on veut une bonne précision.

Il est aussi connu d'utiliser un moteur pas à pas que l'on associe à un réducteur entraînant l'aiguille, afin de réduire le déplacement élémentaire dû à chaque pas et ainsi obtenir la précision voulue. Cet indicateur est complexe, donc coûteux, bruyant et encombrant.

La présente invention vise à pallier ces inconvénients.

A cet effet, elle concerne un procédé d'utilisation d'un indicateur à curseur mobile agencé pour être entraîné en regard d'un cadran par des moyens d'entraînement sensibles à un signal à afficher, et comportant des moyens de commande agencés pour commander par micro-pas un moteur pas à pas relié directement au curseur, procédé dans lequel on maintient le curseur dans une position de repos, contre une butée fixe, correspondant à une position déterminée dans un pas du moteur, caractérisé par le fait que:

    dans une étape préparatoire,

. on règle le signal à afficher pour que le curseur affleure la butée et on mémorise les données de position représentatives de la position correspondante dans le pas et

    dans une séquence d'étapes d'utilisation

. on détermine une succession de données de position représentatives de positions de micro-pas s'étendant sur le pas en partant d'une position pour laquelle le curseur est libre et allant vers la butée et on commande le moteur en lisant cette succession de données et

. par comparaison entre les données de position de la butée et les données de position de chaque micro-pas, on commande un saut dans la lecture des données de position pour supprimer certains micro-pas correspondant à des positions situées dans la plage du pas pour lesquelles l'écart, entre les positions des micro-pas et celle de la butée, est supérieur à un demi-pas.

On évite ainsi l'emploi d'un réducteur, tout en assurant la précision voulue dans la restitution mécanique du signal à afficher. Le mouvement du curseur peut suivre toute trajectoire voulue et on comprendra que le moteur pas à pas peut être du type linéaire.

L'invention sera mieux comprise à l'aide de la description suivante d'un indicateur à curseur mobile et de son procédé d'utilisation, en référence au dessin en annexe sur lequel:

- la figure 1 est une représentation schématique par blocs de l'indicateur,
- la figure 2 illustre la forme des tensions de commande et
- la figure 3 illustre l'évolution des tensions de commande lors de la mise en oeuvre du procédé de l'invention.

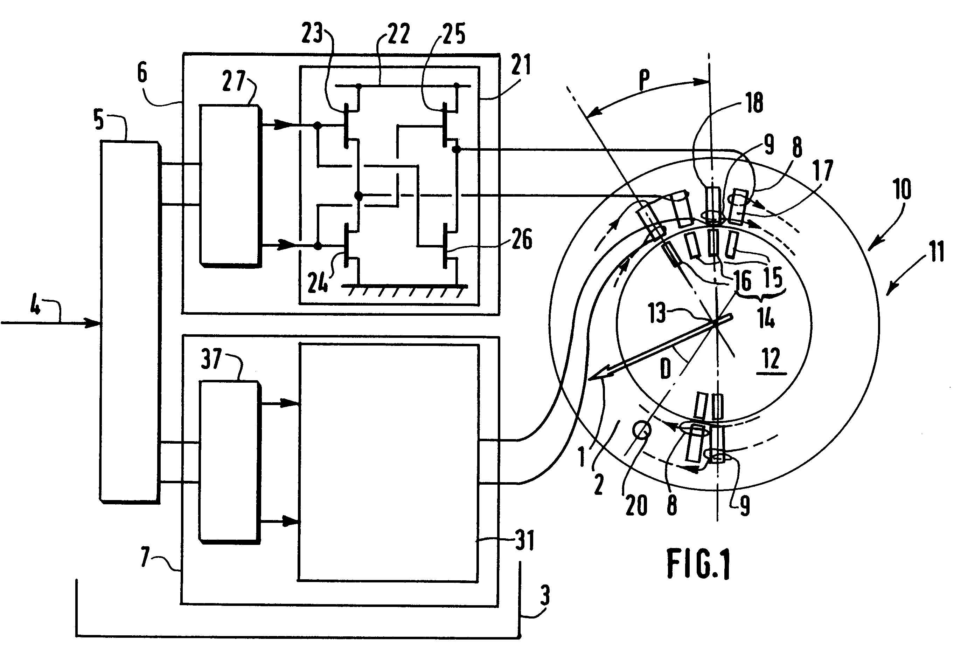

L'indicateur est ici un compte-tours de voiture et comporte un aiguille 1, représentée sur la figure 1, se déplaçant, ici en rotation, devant un cadran 2 sous l'action de moyens d'entraînement 3 recevant un signal de déviation 4 à afficher sous forme d' une déviation de l'aiguille 1.

Les moyens d'entraînement 3 comportent un microcontrôleur 5 commandant deux circuits 6-7 de commande d'alimentation des deux bobines semblables 8-9 d'un moteur pas à pas 10. Le moteur 10 comporte un stator 11, uniquement représenté par ses bobines 8-9, et un rotor 12 d'axe 13.

Le rotor 12 comporte ici douze paires 14 d'aimants permanents globalement référencés 15-16, angulairement réparties de façon régulière sur le pourtour du rotor 12, ce qui définit un pas, d'une paire à l'autre, de P = 360 / 12 = 30 degrés. Les polarités des aimants 15-16 sont régulièrement alternées d'un aimant au suivant.

Le stator 11 comporte, en regard du pourtour du rotor 12, douze paires de pièces magnétiques 17-18 ayant la même disposition angulaire que les aimants 15-16. La bobine 8 est physiquement répartie sur les douze pièces 17 et en commande la magnétisation, tandis que la bobine 9 commande celle des pièces 18. Les champs magnétiques créés sont dirigés vers l'axe 13.

Les bobines 8-9 sont respectivement commandées par deux ponts électroniques identiques en H, 21 et 31, dont l'un, 21, représenté en détail, comporte deux paires de transistors 23-24 et 25-26 reliés en série selon un montage "totem". Chaque paire de transistors 23-24 et 25-26 est alimentée par une tension continue 22, et la bobine 8 relie les points milieu de chaque paire de transistors 23-24, 25-26.

Les grilles des transistors diagonalement opposés, 23 et 26 ainsi que 24 et 25, sont reliées ensemble pour former deux entrées de commande du pont 21. Chacune de ces deux entrées est reliée à une sortie d'un circuit de commande 27, spécifique à chaque entrée. Le circuit de commande 27 est ici un démultiplexeur à quatre sorties, dont seules deux sont utilisées, et à deux entrées d'adresse.

Le pont 31 est, de même, commandé par un circuit de commande 37 identique au circuit 27.

Le microcontrôleur 5 fournit aux circuits 27 et 37 les deux bits d'adresse, spécifiques à chaque circuit, en fonction du signal de déviation 4 reçu d'un capteur de vitesse, non représenté.

Une butée 20 solidaire du cadran 2 correspond à la position de repos de l'aiguille 1.

Le fonctionnement de l'indicateur va maintenant être expliqué, d'un point de vue théorique puis électrique et le procédé d'utilisation sera exposé.

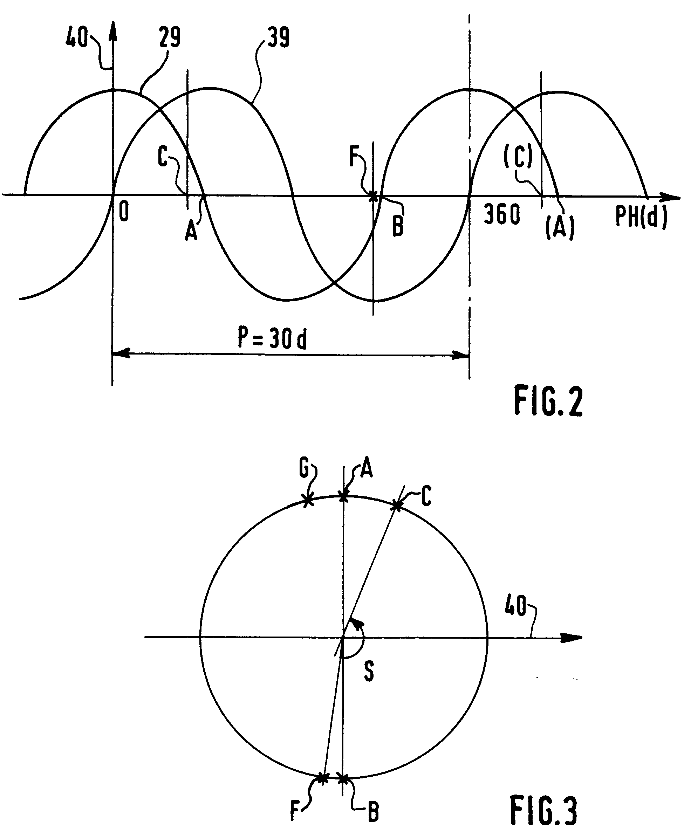

Le moteur fonctionne selon le principe d'un moteur synchrone, c'est-à-dire que, en appliquant aux bobines 8-9 des tensions de commande 29 et 39, représentées sur la figure 2, variant respectivement selon une loi en cosinus et en sinus, le rotor 12 suit le champ magnétique tournant qui en résulte et tourne d'un pas P de 30 degrés pour une rotation de phase PH de 360 degrés dans les tensions de commande 29 et 39. L'axe 40 correspond à un déphasage PH nul.

Entre deux positions, distantes du pas P, pour lesquelles les pièces magnétiques 17-18 seraient respectivement en regard des aimants 15 ou 16 de polarité opposée à la leur, le rotor 12 est, en l'absence de couple résistant, constamment en équilibre sous l'effet de la résultante des forces magnétiques exercées entre les pièces magnétiques 17-18 et les aimants 15-16 les plus proches de chacune.

Ainsi, dans l'indicateur, contrairement au fonctionnement usuel d'un moteur synchrone, qui tourne à fréquence connue, la commande en cosinus 29 et en sinus 39 dépend de la position angulaire que doit occuper le rotor 12 et n'évolue qu'en fonction des variations du signal de déviation 4.

Le fonctionnement électrique de l'indicateur est le suivant.

L'aiguille 1 étant supposée être au repos contre la butée 20, après application, par exemple, du procédé d'utilisation exposé plus loin, qui évite l'utilisation d'un ressort de rappel en spirale, le microcontrôleur 5, recevant le signal de déviation 4, l'applique à une table de conversion, mémorisée localement, pour déterminer un angle de déviation D à appliquer à l'aiguille 1. L'angle de déviation D est ensuite converti en un nombre N (positif quelconque) de périodes angulaires des courants dans les bobines 8-9, égal au rapport D / P.

Le microcontrôleur 5 a en mémoire, grâce à une étape préparatoire de réglage, les valeurs (cosinus 29 et sinus 39) des tensions de commande dans les bobines 8-9 pour lesquelles l'aiguille 1 ne fait qu'affleurer la butée 20, modulo un pas P.

Le microcontrôleur 5 commande, sur une durée qu'il détermine, un déphasage PH des tensions de commande 29 et 39 égal, en degrés, à 360 fois la partie entière du nombre N. Ainsi, si D = 66 degrés, N vaut 66/30 = 2,2 et le rotor 12 est tout d'abord entraîné de 2 P = 60 degrés par un déphasage électronique de 720 degrés dans les tensions, ou courants, de commande 29 et 39.

Le microcontrôleur 5 calcule la valeur finale des deux tensions de commande 29 et 39 par multiplication par 360 degrés de la partie décimale de N, ici 0,2, et augmente en conséquence le déphasage déjà appliqué (720 degrés).

Dans cet exemple, l'amplitude des courants moyens dans les bobines 8-9 est réglée par une modulation de largeur d'impulsions de courant fournies par les ponts 21 et 31. Pour cela, le démultiplexeur 27 reçoit, par l'une de ses deux entrées d'adresse, un bit de sélection qui autorise l'activation de l'une de ses deux sorties, c'est-à-dire qui détermine le sens du courant dans la bobine 8 par mise en conduction de deux transistors diagonalement opposés, 23 et 26 ou 24 et 25.

Le second bit d'adresse sert en fait de bit de verrouillage, c'est-à-dire qu'il contrôle la durée d'activation de la sortie activable. Les impulsions de courant sont engendrées cycliquement à une fréquence ici supérieure à 20 kilohertz, si bien que le courant moyen, dépendant du facteur de forme des impulsions, ne présente que de faibles ondulations de charge et décharge, filtrées mécaniquement grâce à l'inertie du rotor 12.

Le circuit 37 a le même fonctionnement, avec des commandes qui lui sont propres. La phase de ses impulsions et même sa fréquence de fonctionnement peuvent être indépendantes de celles du circuit 27.

Dans cet exemple, la période de déphasage des tensions de commande est divisée en 128 micro-pas, soit 32 par quadrant, ce qui entraîne que le pas mécanique P = 30 degrés est aussi divisé en 128 micro-pas.

Le microcontrôleur 5 comporte en mémoire morte une table de 32 valeurs de sinus pour 32 valeurs d'angles régulièrement répartis de 0 à 90 degrés, les valeurs pour les trois autres quadrants s'en déduisant. La précision angulaire est ainsi de 0,5 micro-pas, soit 30 degrés / 2 x 128 micro-pas = 0,1 degré environ.

Il est aussi prévu, ici, de contrôler la vitesse de rotation du rotor 12. Pour cela, le microcontrôleur 5 commande chaque micro-pas à un rythme déterminé de période Tmp, les impulsions de courant se répétant avec des durées inchangées pendant chaque période Tmp des micro-pas. La vitesse de rotation Vr du rotor 12 est donc:

$$Vr = 30 \text{ degrés} / 128 \text{ micro - pas x } Tmp$$

Le microcontrôleur 5 peut aussi modifier la vitesse angulaire Vr en choisissant une autre valeur pour la période Tmp, par exemple pour éviter un retard trop visible dans le cas d'un grand déplacement, tandis que de petites oscillations du signal 4 seront filtrées par une vitesse Vr limitée.

On comprendra que l'écart d'angle de phase des commandes 29 et 39 pourrait être différent de 90 degrés, c'est-à-dire que l'écart mécanique angulaire entre les deux aimants 15-16 ainsi qu'entre les deux pièces magnétiques 17-18, de chaque paire, peut être modifié pour s'adapter à des commandes présentant un déphasage différent de celui du présent exemple. En effet, bien que les commandes en cosinus 29 et en sinus 39 présentent l'avantage d'exercer un couple constant sur le rotor 12, il suffirait qu'une au moins des commandes varie pour que le rotor 12 tourne. En particulier, l'utilisation d'une modulation supplémentaire, modifiant la modulation en cosinus et sinus de cet exemple, permettrait d'obtenir d'autres champs magnétiques résultants, correspondant à des positions stables supplémentaires, donc fournissant une meilleure précision angulaire.

Le procédé d'utilisation de l'indicateur, pour maintenir au repos l'aiguille 1 contre la butée 20, va maintenant être exposé.

Dans une étape préparatoire, un opérateur règle le signal 4 pour que l'aiguille 1 affleure la butée 20 et, après vérification visuelle, il commande la mémorisation, dans le microcontrôleur 5, des valeurs correspondantes des deux tensions de commande 29 et 39, qui sont des données de position représentatives de la position correspondante dans le pas P. La valeur de phase correspondante des tensions 29 et 39 sert de référence dans la suite de l'exposé et, pour la simplicité, elle est supposée être égale à 90 degrés (point A de la figure 3) par rapport à l'axe 40, c'est-à-dire que le courant en cosinus 29 dans la bobine 8 est nul, tandis que le courant en sinus 39 de la bobine 9 a une valeur maximale. On comprendra que cette hypothèse ne présente pas un caractère impératif qui restreindrait la portée du procédé, car il est possible de définir des écarts angulaires, comme exposé plus loin, par rapport à toute position angulaire connue.

Le champ tourne dans le sens trigonométrique sur la figure 3, ce qui correspond au sens trigonométrique de rotation de l'aiguille 1 vers la butée 20 sur la figure 1.

Ensuite, dans une séquence d'étapes d'utilisation, lorsque l'aiguille 1 doit revenir contre la butée 20, le microcontrôleur 5 commande cycliquement en permanence l'exécution de cycles de micro-pas pour la faire revenir vers la butée 20.

Le rotor 12 suit le champ magnétique tournant qui, en l'absence de contact de l'aiguille 1 sur la butée 20, le fait tourner de P = 30 degrés par période de déphasage électrique de 360 degrés dans les commandes 29 et 39 des courants des bobines 8-9.

Le déphasage de 360 degrés des commandes 29 et 39 s'effectue par envoi d'un nombre de micro-pas inférieur aux 128 micro-pas possibles, prévus dans cet exemple d'indicateur. En effet, un peu avant (point F) que la phase de la commande n'atteigne la phase du point A (ici 90 degrés) augmentée de 180 degrés, soit ici 270 degrés (point B), le microcontrôleur 5 l'accroît brusquement d'une valeur S inférieure, ici très peu inférieure, à 180 degrés, pour passer au point C.

Comme le saut de phase est inférieur à 180 degrés, le rotor 12, fonctionnant en moteur synchrone, subit encore un couple moteur de même signe que celui qui l'entraînait avant le saut dans le sens trigonométrique, donc ne décroche pas.

Au début du rappel de l'aiguille 1 vers la butée 20, l'aiguille 1 est usuellement libre car elle présente une déviation indéterminée dépassant en général P = 30 degrés par rapport à la butée 20. Elle revient alors vers la butée 20 par une suite de rotations, à chaque fois d'un pas, à vitesse normale (phases de C, A, F) en alternance avec des sauts (phases de F à C).

Si, par contre, l'aiguille 1 est dans le pas P contenant la butée 20, le rotor 12 va décrocher lorsque le champ tournant aura dépassé de plus de 180 degrés (B) la position angulaire (A) de la butée 20, c'est-à-dire pour le demi-cercle B C A.

Comme la plus grande partie (B C) de ce demi-cercle B C A n'existe plus temporellement, au niveau des commandes 29 et 39, du fait du saut de phase de F à C, l'aiguille 1 ne subit, pendant un très court instant (parcours C A), qu'un faible couple de décollement d'avec la butée 20, qui peut même être sans effet mécanique. L'aiguille 1 reste ainsi contre la butée 20, alors qu'elle s'en écarterait en l'absence de saut à chaque pas P de rotation du champ tournant.

La distance angulaire entre les points F et B est une marge de sécurité pour tenir compte de l'incertitude éventuelle sur la position A de la butée 20.

On remarquera que l'on peut maintenir à une valeur minimale le couple de décollement de l'aiguille 1 par rapport à la butée 20 en parcourant à plus grande vitesse la plage angulaire allant de C à A, ou un peu au-delà pour tenir compte de son incertitude de position, par un ou des sauts de phase. En effet, connaissant l'inertie du rotor 12, on peut faire évoluer la phase de commande partant du point C le temps juste nécessaire pour que le rotor 12 se recale approximativement, puis la faire sauter au point G, où le couple d'appui est positif (sens trigonométrique).

Il peut être prévu de contrôler le mouvement du rotor 12 et d'amortir ses oscillations lors des sauts de phase, en appliquant, ponctuellement dans le temps, des commandes pour des déviations intermédiaires. Par exemple, connaissant l'inertie du rotor 12 et le couple appliqué, le microcontrôleur 5 peut appliquer des commandes 29 et 39 aux instants théoriques de passage à grande vitesse du rotor 12 aux positions angulaires 270 (B), 315, 360 et 45 degrés, par exemple, ce qui a pour effet de recaler les positions angulaires du rotor 12, donc sa vitesse, selon une loi déterminée. De même, l'arrivée au point C, qui peut alors être reportée au point G, peut être amortie par l'envoi de commandes 29 et 39 de moins en moins déphasées angulairement l'une par rapport à la suivante, avant l'arrivée au point C.

## Revendications

1. Procédé d'utilisation d'un indicateur à curseur mobile (1) agencé pour être entraîné en regard d'un cadran (2) par des moyens d'entraînement (3) sensibles à un signal (4) à afficher, et comportant des moyens de commande (5-7) agencés pour commander par micro-pas un moteur pas à pas (10) relié directement au curseur (1), procédé dans lequel on maintient le curseur (1) dans une position de repos, contre une butée fixe (20), correspondant à une position déterminée dans un pas du moteur (10), caractérisé par le fait que:

   ▪ dans une étape préparatoire,

   . on règle le signal à afficher (4) pour que le curseur (1) affleure la butée (20) et on mémorise les données de position représentatives de la position correspondante (A) dans le pas et

   ▪ dans une séquence d'étapes d'utilisation

      . on détermine une succession de données de position représentatives de positions de micro-pas s'étendant sur le pas en partant d'une position pour laquelle le curseur (1) est libre et allant vers la butée (20) et on commande le moteur (10) en lisant cette succession de données et

      . par comparaison entre les données de position (A) de la butée (20) et les données de position de chaque micro-pas, on commande un saut dans la lecture des données de position pour supprimer certains micro-pas correspondant à des positions situées dans la plage du pas pour lesquelles l'écart, entre les positions des micro-pas et celle de la butée (20), est supérieur à un demi-pas.

2. Procédé selon la revendication 1, dans lequel on commence le saut de micro-pas avant que l'écart de positions n'ait atteint un demi-pas.

3. Procédé selon l'une des revendications 1 et 2, dans lequel on effectue le saut par une suite de sauts intermédiaires.

FIG.1

FIG.2

FIG.3

EP 0 632 276 A1

**Office européen des brevets**

# RAPPORT DE RECHERCHE EUROPEENNE

Numero de la demande

EP 94 40 1455

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | EP-A-0 330 942 (ASULAB S.A.) <br> * colonne 7, ligne 10 - ligne 24; revendication 1; figure 1 * <br> --- | 1 | G01R7/00 <br> G01D7/00 |
| A | MACHINE DESIGN, <br> vol.59, no.26, Novembre 1987, CLEVELAND, OHIO, USA <br> pages 99 - 102 <br> R. HORBER 'Permanent-Magnet Steppers Edge into Servo Territory' <br> page 100, 'Anatomy of a high pole-count motor' <br> ----- | 1-3 | |
| | | | **DOMAINES TECHNIQUES RECHERCHES (Int.Cl.6)** <br> G01R <br> H02K |

Le présent rapport a été établi pour toutes les revendications

| Lieu de la recherche | Date d'achèvement de la recherche | Examinateur |
|---|---|---|
| LA HAYE | 17 Octobre 1994 | Chapple, I |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)